# EUROPEAN PATENT APPLICATION

(11) **EP 1 487 056 A1**
(43) Date of publication of application: **15.12.2004**
(21) Application number: 03744534.3
(22) Date of filing: 20.03.2003
(51) Int. Cl.: H01R 11/01

(54) **FLEXIBLE GOOD CONDUCTIVE LAYER AND ANISOTROPIC CONDUCTIVE SHEET COMPRISING SAME**

(30) Priority: 20.03.2002 JP 2002079747
(71) Applicant: J.S.T. Mfg. Co., Ltd., Osaka-shi, Osaka 650-0000 (JP)
(72) Inventor: HASEGAWA, Miki; c/o J.S.T. Mfg. Co., Ltd., Nishikamo-gun, Aichi 470-0201 (JP)
(74) Representative: TER MEER STEINMEISTER & PARTNER GbR
(86) International application number: PCT/JP2003/003461
(87) International publication number: WO 2003/079495

(57) **Abstract**

A conductive layer that can be easily handled having good electric conductivity and an anisotropic conductive sheet obtained by adhering the conductive layer to a base member made of a conductive member. A flexible good conductive layer comprises a plurality of layers and is adhered to the base member so will not to be broken even when the base member is distorted due to the handling. The flexible good conductive layer (25) can be adhered to a base member (24) made of a flexible material, and is constituted by at least a set of a layer (e.g., 254) of a flexible material, and a layer (e.g., 256) of a material having good conductivity and is electrically contacted to the layer (e.g., 254) made of the flexible material. The flexible good conductive layer (25) is adhered to the anisotropic conductive sheet (10) in which the conductive members (24) are scattered in the nonconductive matrix, and the flexible good conductive layer (25) is contacted to the conductive members (24).

## Description

### FIELD OF THE INVENTION

This invention relates to a conductive layer that can be easily handled having good electric conductivity and to an anisotropic conductive sheet using this conductive layer. More particularly, the present invention relates to a conductive layer comprising a plurality of layers and to an anisotropic conductive sheet using the multi-layered conductive layer, which is interposed between a circuit board such as a substrate and various circuit parts (components) to render conductive paths.

### RELATED ART

It is a widely accepted practice in the field of general printed boards to deposit metal having good electric conductivity on a substrate as an electrically conductive layer (hereinafter referred to as "conductive layer") by vacuum evaporation in order to impart electric conduction in the direction of plane of the substrate. The above conductive layer is usually composed of a single layer. However, the printed board has a sufficiently high rigidity and it does not usually happen that the conductive layer is destroyed when being handled.

When the rigidity of the substrate on which the conductive layer is deposited is not sufficient, however, the substrate is distorted due to bending, twisting, stretching or contraction when being handled, whereby the distortion is transmitted to the conductive layer which is, then, deformed to develop cracking resulting in a destruction. It is therefore probable that the electric conduction becomes insufficient in the direction of the plane.

With the modern trend of realizing electronic equipment in small sizes and in reduced thickness, further, an increasing importance has been placed on the necessity of connection among fine circuitries and between fine portions and fine circuitry, and an electric conduction has been realized by interposing an anisotropic conductive elastomer sheet between the electronic parts and the circuit board. In the anisotropic conductive elastomer sheet, the conductivity and non-conductivity must be controlled in relation to the directions thereof.

The anisotropic conductive elastomer sheet stands for a sheet which exhibits conductivity in one direction only. For instance, the anisotropic conductive elastomer sheet may be the one that exhibits conductivity in the direction of thickness only, or the one which exhibits conductivity in the direction of thickness only when it is pressed in the direction of thickness. The anisotropic conductive elastomer sheet is characteristic in accomplishing a compact electric connection without such means as soldering or mechanical fitting and accomplishing a soft connection by absorbing mechanical shock and distortion. Owing to such characteristics, therefore, the anisotropic conductive eiastomer sheet has been extensively used as connectors for achieving electric connection relative to circuit devices such as printed circuit boards, leadless chip carriers and liquid crystal panels in the fields of cell phones, electronic computers, electronic digital timepieces, electronic cameras, computers and the like.

In the electric inspection of the circuit devices such as printed circuit boards and semiconductor integrated circuits, further, the anisotropic elastomer sheet has heretofore been interposed between a region of electrodes to be inspected of the circuit device and a region of inspecting electrodes of the circuit board for inspection in order to achieve electric connection between the electrodes to be inspected that is formed at least on one surface of the circuit device to be inspected and the inspecting electrodes formed on the surface of the circuit board for inspection.

It is known that an example of the above anisotropic conductive elastomer sheet may be obtained by cutting an anisotropic conductive block in a thin sheet such that the block that is formed integrally with thin metal wires disposed in parallel and insulating material enclosing the metal wires is cut in a direction orthogonal to the direction of the thin metal wires (JP-A-2000-340037).

In the anisotropic conductive film with thin metal wires, however, it is difficuit to shorten distance between such thin metal wires and to secure anisotropic conductivity with a fine pitch as required by recent highly integrated circuit boards and electronic components although the sheet is strongly resistant against deformation. Further, it is likely that thin metal wires are to be buckled with compressive force or the like during the use thereof and easily pulled out after repetitive use so that the anisotropic conductive film may fail to keep its function to a sufficient degree.

In view of the above tasks, the present invention provides a flexible good conductive layer which is adhered to a base plate such that the layer may not be destroyed even when the base plate does not have a large rigidity or even when the base plate is distorted while being handled. The present invention further constitutes an anisotropic conductive sheet by using the flexible good conductive layer to exhibit high electric conductivity in the direction of conduction and high durability, having a fine pitch required by the modern highly integrated circuit boards and electronic parts preventing conductive members such as metals from slipping out.

### DISCLOSURE OF THE INVENTION

In order to solve the above situations, the present invention provides a flexible good conductive layer having electric conductivity, which is a flexible good conductive layer that can be adhered to a base member made of a flexible material, the flexible good conductive layer being made of at least a set of a layer of a flexible material, and a layer of a material having good conductivity and is electrically contacted to the layer made of the flexible material. Further, the flexible good conductive layer is applied to an anisotropic conductive sheet in which conductive members are scattered in a nonconductive matrix in a manner that the flexible good conductive layer is in contact with the conductive members.

More specifically, the present invention provides the following.
(1) A flexible good conductive layer having flexibility so as to be adhered to a substrate made of flexible material, comprising: a flexible layer made of flexible material; and a good conductive layer made of material having good electric conductivity, the conductive layer being mechanically and electrically contacted to the flexible layer; wherein the good conductive layer is adhered to the substrate via the flexible layer.
(2) The flexible good conductive layer according to (1), wherein the flexible layer is made of flexible metal, and wherein the good conductive layer is made of meta! of good electric conductivity.
(3) The flexible good conductive layer according to (2), wherein the flexible metal is indium, tin, lead or an alloy thereof, and wherein the metal of good electric conductivity Is copper, silver, gold or an alloy thereof.
(4) The flexible good conductive layer according to any one from (1) to (3), wherein a value of specific resistivity of the flexible material is at least two times as large as a value of specific resistivity of the material of good electric conductivity.
(5) The flexible good conductive layer according to any one from (1) to (4), wherein an adhesive layer is disposed between the substrate to which the flexible good conductive layer is adhered and the flexible good conductive layer.
(6) An anisotropic conductive sheet expanding on a first plane, wherein when a first direction contained in said first plane is denoted as X-direction, a direction orthogonal to X-direction and contained in said first plane is denoted as Y-direction and a direction orthogonal to X-direction and Y-direction is denoted as Z-direction, wherein the anisotropic conductive sheet has a predetermined thickness in Z-direction and a front surface and a back surface substantially in parallel with X-Y plane, the anisotropic conductive sheet comprising: a matrix made of nonconductive material (hereinafter referred to as "nonconductive matrix") expanding on X-Y plane, scattered conductive portions made of conductive material scattered in the nonconductive matrix, and the flexible good conductive layer according to any one from (1) to (5) in contact with the scattered conductive portions, wherein the base member made of said flexible material corresponds to said conductive member.
   Further, an anisotropic conductive sheet expanding on a first plane, wherein when a first direction contained in said first plane is denoted as X-direction, a direction orthogonal to X-direction and contained in said first plane is denoted as Y-direction and a direction orthogonal to X-dlrection and Y-direction is denoted as Z-direction, wherein the anisotropic conductive sheet has a predetermined thickness in Z-direction, and a front surface and a back surface substantially in parallel with the first plane, the anisotropic conductive sheet comprising: a nonconductive matrix expanding on the first plane, scattered conductive portions made of a flexible material scattered In the nonconductive matrix, and a flexible good conductive layer of flexibility adhered to said scattered conductive portions between said scattered conductive portions and said nonconductive matrix, wherein said flexible good conductive layer comprises a flexible layer made of said flexible material arranged on the side of said scattered conductive portions serving as the base member and a good conductive layer made of material of good electric conductivity mechanically and electrically contacted to said flexible layer, wherein said good conductive layer being a flexible good conductive layer is adhered to said scattered conductive portions serving as said base member via said flexible layer.
(7) The anisotropic conductive sheet according to (6), wherein the scattered conductive portions penetrate the anisotropic conductive sheet from the front surface to the back surface in Z-direction, and wherein the flexible good conductive layer extends along the surface of the scattered conductive portions.
(8) An anisotropic conductive sheet expanding on a first plane, wherein when a first direction contained in said first plane is denoted as X-direction, a direction orthogonal to X-direction and contained in said first plane is denoted as Y-direction and a direction orthogonal to X-direction and Y-direction is denoted as Z-direction, wherein the anisotropic conductive sheet has a predetermined thickness in Z-direction and a front surface and a back surface substantially in perallel with said first plane (which can also be referred to as "X-Y plane"), the anisotropic conductive sheet comprising: strip-like members of a striped pattern having a width in Y-direction and extending in X-direction, the strip-like members having conductive pieces made of conductive material and nonconductive pieces made of nonconductive material aiternately arranged along X-direction; and nonconductive strip-like members having a width in Y-direction and extending in X-direction, the nonconductive strip-like members being made of nonconductive material, wherein the strip-like members of the striped pattern and the nonconductive strip-like members are arranged side by side in Y-direction, and wherein the flexible good conductive layer according to any one from (1) to (5) is in contact with said conductive pieces, and the base member made of said flexible material corresponds to said conductive pieces.
   Further, an anisotropic conductive sheet expanding on a first plane,
   wherein when a first direction contained in said first plane is denoted as X-direction, a direction orthogonal to X-direction and contained in said first plane is denoted as Y-direction and a direction orthogonal to X-direction and Y-direction is denoted as Z-direction, wherein the anisotropic conductive sheet has a predetermined thickness in Z-direction, and a front surface and a back surface substantially in parallel with said first plane (which can also be referred to as "X-Y plane"), the anisotropic conductive sheet comprising: strip-like members of a striped pattern having a width in Y-direction and extending in X-direction, the strip-like members including; conductive pieces of conductivity and nonconductive pieces of nonconductivity which are alternately arranged along X-direction; and nonconductive strip-like members being made of a nonconductive material and having a width in Y-direction and extending in X-direction, wherein the strip-like members and the nonconductive strip-like members are arranged relative to each other along Y-direction, wherein flexible good conductive layers of flexibility adhered to said conductive pieces between said conductive pieces and said nonconductive pieces, which are neighboring in the strip-like members of a striped pattern, are provided, and wherein said flexible good conductive layer comprises: a flexible layer made of said flexible material arranged on a side of said conductive pieces serving as a base member; and a good conductive layer made of material of good electric conductivity mechanically and electrically contacted to said flexible layer, and wherein said good conductive layer is a flexible good conductive layer adhered to said conductive pieces serving as the base member via said flexible layer.
(9) The anisotropic conductive sheet according to (6) or (7), wherein the flexible good conductive layer comprises an adhesive layer arranged on a side of the base member and a conductive layer, wherein said conductive layer comprises a flexible layer and a good conductive layer electrically contacted to the flexible layer, and wherein said conductive layer is adhered to the substrate via said adhesive layer.
(10) The anisotropic conductive sheet according to (9), wherein said adhesive layer is made of indium tin oxide. (11) The anisotropic conductive sheet according to (9) or (10), wherein the adhesive layer of the flexible good conductive layer is arranged on a side of the nonconductive matrix when the flexible good conductive layer is in contact with the nonconductive matrix.
(12) The anisotropic conductive sheet according to any one of (6), (7) and (9) to (11), wherein the nonconductive matrix comprises a nonconductive elastomer, and the scattered conductive portions comprise a conductive elastomer.
(13) The anisotropic conductive sheet according to any one of (6), (7) and (9) to (12), wherein the scattered conductive portions are protruded as compared to the surrounding nonconductive matrix.
(14) A method of manufacturing a flexible anisotropic conductive sheet having a predetermined thickness, and predetermined front and back surfaces on the front and back across the thickness, the method comprising: a step of adhering a flexible good conductive layer on the surface of a conductive sheet (A) made of a conductive material to obtain a conductive sheet (A) with the flexible good conductive layer; a step of alternately laminating the conductive sheet (A) with the flexible good conductive layer obtained in the step of adhering the layers and a nonconductive sheet (B) to obtain an AB sheet laminate (C); a first step of cutting the AB sheet laminate (C) obtained in the step of obtaining the AB sheet laminate to obtain a zebra-like sheet in a predetermined thickness; a step of alternately laminating the zebra-like sheet obtained in the first cutting step and a nonconductive sheet (D) to obtain a ZD sheet laminate (E); and a second step of cutting the zebra-D sheet laminate (E) obtained in the step of obtaining the ZD sheet laminate with a predetermined thickness.

The present invention provides a flexible good conductive layer having electric conductivity that can be adhered to a substrate made of flexible material, the flexible good conductive layer being composed of at least a set of a layer made of flexible material and a layer of material having good conductivity which is electrically contacted to the layer made of the flexible material. As the flexible material, there can be used organic material such as conductive macromolecule, inorganic material or metal material, and, as the good conductive material, there can be used graphite, organic material such as conductive macromolecule, inorganic material, metal material or mixture thereof, however, the flexible or good conductive material is not limited to them. Here, when all constituent materials belong to metal, the flexible good conductive layer may be called metal layer. Here, the substrate made of flexible material may be deformed such that the flexible good conductive layer could be destroyed during handling, being assembled or applied to a subject component or the like, or being used as a product because of distortion if the flexible good conductive layer is single-layered. For instance, the substrate made of macromolecule or elastomer is likely to be deformed in such a manner. Or, even a substrate made of rigid material is likely to be deformed when the substrate is thin in the thickness. In general, the substrate serves as a base member and may include a conductive member or a conductive piece.

Further, the layer made of flexible material may be the one made of metal which flexibly deforms itself to meet the external deformation of the substrate or the like, and may have resistance against electrical disconnection due to cracks and breakage thereof. Further, the layer made of material having good electric conductivity may be the one made of material having electric conductivity higher than that of the above flexible material in an environment of use. Further, the metal having good electric conductivity may have electric conductivity higher than that of the above flexible material and more preferably, may be at least two times as great as the above flexible material and, yet more preferably, may be at least five times as great as the above flexible material. The layers of the above materials are combined together based on discovery that one kind of material may not necessarily be enough to satisfy both flexibility and good electric conductivity.

As flexible'metal, there can be exemplified pure metal such as indium, tin or lead, or alloys such as indium and tin. According to "Rikagaku Jiten" (Iwanami Shoten Co.), indium is flexible yet having resistivity of 8.4 x 10⁻⁶ Ωcm, tin has resistivity of 11.4 x 10⁻⁶ Ωcm, and lead has resistivity of 20.8 x 10⁻⁶ Ωcm. On the other hand, as the metal having good electric conductivity, there can be exemplified pure metal such as copper, silver, gold and alloys thereof, Similarly, according to "Rikagaku Jiten" (Iwanami Shoten Co.), copper has resistivity of 1.72 x 10⁻⁶ Ωcm, silver has resistivity of 1.82 x 10⁻⁶ Ωcm, and gold has resistivity of 2.2 x 10⁻⁶ Ωcm. It will therefore be learned that flexible metal has resistivity at least twice as great as metal having good conductivity.

Further, the layer made of material having good conductivity which is electrically contacted to a layer made of flexible material may be the one which can let the electricity go through the layer of flexible material being contacted even when the layer made of good conductive metal is broken, for example, due to handling so that the electricity cannot flow through the broken portion, which is bypassed by the layer of flexile metal. As described above, the flexible metal has a low electric conductivity. Once the broken portion is by-passed, therefore, electricity can be conducted to the other side of the layer made of good conductive metal beyond the the broken portion. Owing to this structure, the layer made of flexible metal works as a redundant system for the passage of electricity. When there is diffusion to some extent between the layers, adhesion is improved between the layers and, as a result, It is considered that the multi-layer function is improved. However, if the diffusion takes place too much to establish a completely mixed state, the multi-layer function decreases.

According to the present invention, in an anisotropic conductive sheet in which the conductive members are scattered in the nonconductive matrix, it may be characterized in that the flexible good conductive layer is in contact with the conductive member and the base member made of the flexible material is the conductive member, Further, the nonconductive matrix is a sheet member made of nonconductive material, works to insulate the scattered conductive members in the direction of a plane to maintain non-conductivity in the direction contained in the plane of the anisotropic conductive sheet. Usually, the nonconductive matrix is all connected (continuous) In the anisotropic conductive sheet to form an anisotropic conductive sheet. The nonconductive matrix, however, may not be continuous. Further, the scattered conductive members stand for that one or more conductive members are existing in a state of being separated away from each other in the direction contained in the plane of the sheet. Here, the description reads that "the base member made of the flexible material is the conductive member" and, hence, the flexible good conductive layer may be directly adhered to the conductive member,

Further, the words "penetrating the anisotropic conductive sheet from the front surface to the back surface in Z-direction", may mean that the conductive members penetrate throughout In the direction of thickness, or may mean that the conductive members appear on both front and back sides of the anisotropic conductive sheet, and may have a function for electrically connecting the front side to the back side. "The flexible good conductive layer is in contact with the conductive pieces" may mean that the flexible good conductive layer is electrically connected to the conductive pieces. The flexible good conductive layer has conductivity higher than the conductive pieces. When the electricity flows in parallel (as being parallel-connected), therefore, the electric conductivity of the flexible good conductive layer becomes dominant as a whole. As a result, the resistance between the front and the back of the sheet becomes low when the flexible good conductive layer is adhered.

Further, the anisotropic conductive sheet according to the present invention may be characterized in that the flexible good conductive layer is running along the conductive members that are penetrating through the sheet in the direction of thickness. Namely, electricity flowing in the direction of thickness of the sheet may flow through the conductive members and the flexible good conductive layer in parallel, and the conductivity of the sheet in the direction of thickness is often dominated chiefly by the electric conductivity of the flexible good conductive layer. Therefore, the resistance between the front and back of the sheet may often become equal to the resistance of the flexible good conductive layer.

Further, the anisotropic conductive sheet according to the present invention includes strip-like members of a striped pattern having conductive members with conductivity and nonconductive members without conductivity alternately arranged, and nonconductive strip-like members made of nonconductive material, which are arranged relative to each other, and wherein a flexlble good conductive layer is in contact with the conductive members. Being conductive may mean that the anisotropic conductive sheet having the above constitution exhibits sufficiently high conductivity in the direction of conduction. Usually, it is desirable that the resistance among the terminals to which the connection is made is, usually, not larger than 100 Ω (preferably, not larger than 10 Ω and, more preferably, not larger than 1 Ω). The strip-like members of the striped pattern alternately arranged are slender members including conductive members and nonconductive members that are alternately arranged and exhibiting a striped pattern If the conductive members and the conductive members were of different colors. In practice, they need not appear in a striped pattern. Here, the conductive members may include conductive pieces and the nonconductive members may include nonconductive pieces. The alternate arrangement needs not spread all over the whole strip-like members but may exist in only a portion thereof. Further, the flexible good conductive layer is in contact with the conductive pieces may stand for the electric connection in the same manner as described above.

The anisotropic conductive sheet of the present invention, further, may be characterized in that the flexible good conductive layer comprises the adhesive layer and the conductive layer. Here, the adhesive layer may be the one for improving the adhesion to the conductive members while the flexible good conductive layer comes In contact with the conductive members. The conductive layer of the flexible good conductive layer has physical and chemical properties, which are greatly different from the physical and chemical properties of the conductive members, and can impart a function such as exhibiting properties lying midway between those of the conductive layer and the conductive members, and improving the adhesion between them. Therefore, it may be characterized in that the adhesive layer is arranged on the side of the conductive members which are in contact with the flexible good conductive layer using the adhesive layer as a constituent element. For example, distortion stemming from a difference in the thermal expansion can be lowered or absorbed.

Further, it may be characterized in that the adhesive layer Is arranged on the side of the nonconductive matrix while the flexible good conductive layer is in contact with the nonconductive matrix. Here, the words "in contact with the nonconductive matrix" may mean that the flexible good conductive layer is in physical (mechanical) contact with the nonconductive matrix, because the nonconductive matrix is insulating. Being arranged on the side of the nonconductive matrix may mean that the adhesive layer is positioned between the conductive layer and the nonconductive matrix. Here, the adhesive layer may be the one for improving the adhesion to the nonconductive matrix while the flexible good conductive layer is in contact with the nonconductive matrix. The conductive layer of the flexible good conductive layer has physical and chemical properties that are greatly different from the physical and chemical properties of the conductive members, and can impart a function such as exhibiting properties lying midway between those of the conductive layer and the conductive members, and improving the adhesion between them. Therefore, it may be characterized In that the adhesive layer is arranged on the side of the conductive members which are in contact with the flexible good conductive layer using the adhesive layer as a constituent element. For example, distortion stemming from a difference in the thermal expansion can be lowered or absorbed.

It may be characterized in that the adhesive layer comprises a metal oxide or a metal. Examples of the metal oxide include indium oxide, tin oxide, titanium oxide, a mixture thereof and a compound thereof, and examples of the metal include chromium. For example, it may be characterized in that the adhesive layer comprises indium tin oxide (or indium oxide/tin oxide). Indium tin oxide (or indium oxide / tin oxide) is a ceramic material abbreviated as ITO and has a high electric conductivity. The conductive layer may be made of a metal having good conductivity. If the metal has electric conductivity higher than that of the conductive members and if electricity flows in parallel therewith, the electric resistance as a whole is dominated by the electric resistance of the metal.

In the anisotropic conductive sheet of the present invention, further, it may be characterized in that the nonconductive matrix comprises a nonconductive elastomer, and the conductive members comprise a conductive elastomer.

The conductive elastomer stands for elastomer having electric conduction and is, usually, elastomer blended with a conductive material so as to lower the volume resistivity (smaller than, for example, 1 Ω-cm). Concrete examples of the elastomer include butadiene copolymers such as natural rubber, polyisoprene rubber, butadiene / styrene, butadiene acrylonitrile, butadiene / isobutylene, conjugated diene rubber and hydrogenated compounds thereof; block copolymer rubbers such as styrene/butadiene / dlene block copolymer rubber, styrene / isoprene block copolymer, and hydrogenated compounds thereof; and chloroprene copolymer, vinyl chloride / vinyl acetate copolymer, urethane rubber, polyester rubber, epichlorohydrin rubber, ethylene / propylene copolymer rubber, ethylene / propylene / diene copolymer rubber, soft liquid epoxy rubber, silicone rubber and fluorine-contained rubber. Among them, the silicone rubber is preferably used owing to its excellent heat resistance, cold resistance, chemical resistance, aging resistance, electric Insulation and safety. The elastomer may be blended with a conductive substance like a powder (flakes, small pieces, foils, etc. are allowable) of a metal such as gold, silver, copper, nickel, tungsten, platinum, palladium or any other pure metal, SUS, phosphor bronze or beryllium copper, or a nonmetallic powder (flakes, small pieces, foils, etc. are allowable) such as of carbon to obtain a conductive elastomer.

The nonconductive elastomer stands for those without conductivity. Concrete examples of the nonconductive elastomer include butadiene copolymers such as natural rubber, polylsoprene rubber, butadiene/styrene. butadiene / acrylonitrile, butadiene / isobutylene, conjugated diene rubber and hydrogenated compounds thereof; block copolymer rubbers such as styrene/butadiene / diene block copolymer rubber, styrene / isoprene block copolymer, and hydrogenated compounds thereof; and chloroprene copolymer, vinyl chloride / vinyl acetate copolymer, urethane rubber, polyester rubber, epichlorohydrin rubber, ethylene / propylene copolymer rubber, ethylene / propylene / diene copolymer rubber, soft liquid epoxy rubber, silicone rubber and fluorine-contained rubber. Among them, the silicone rubber is preferably used owing to Its excellent heat resistance, cold resistance, chemical resistance, aging resistance, electric insulation and safety. The nonconductive elastomer usually has a high volume resistivity (e.g., not smaller than 1 MΩ-cm at 100 V) and is nonconductive.

In order to chemically bond the conductive elastomer and the nonconductive elastomer, a coupling agent may be applied between them: The coupling agent is the one for coupling these members, and may include an adhesive usually placed in the market. Concrete examples include coupling agents of the types of silane, aluminum and titanate. Among them, a silane coupling agent is favorably used.

In the anisotropic conductive sheet of the present invention, it may be characterized in that the conductive members are protruded as compared to the nonconductive matrix. Protruding stands for a case where the portion of the conductive member is thicker than the portion of the nonconductive matrix in the thickness of the anisotropic sheet, a case where the position of the upper surface of the nonconductive matrix is lower than the position of the upper surface of the conductive member when the anlsotropic conductive sheet is horizontally placed, and/or a case where the position of the lower surface of the nonconductive matrix is higher than the position of the lower surface of the conductive member when the anisotropic conductive sheet is horizontally placed. Then, the electric contact becomes more reliable to the electronic parts and to the terminals of the substrate. A method of manufacturing an anisotropic conductive sheet according to the present invention comprises:
a step of adhering a flexible good conductive layer on the surface of a conductive sheet made of conductive members to obtain a conductive sheet (A) with the flexible good conductive layer; a step of alternately laminating the conductive sheet with the flexible good conductive layer and a sheet (B) made of nonconductive members to obtain a laminate (C); a step of cutting the laminate (C) to obtain a zebra-like sheet in a predetermined thickness; a step of alternately laminating the zebra-like sheet and a sheet made of nonconductive members to obtain a laminate (E); and a second step of cutting the laminate (E) in a predetermined thickness.
   Here, the conductive sheet may be a sheet of single kind or a collection of sheets of different kinds. For example, the conductive sheet may be a collection of sheets of the same material but having different thicknesses. In the step of adhering the flexible good conductive layer onto the surface of the conductive sheet made of the conductive members, the flexible good conductive layer may be adhered onto one surface or both surfaces of the sheet. The flexible good conductive layer can be adhered by any one of the vapor phase method, liquid phase method or solid phase method or by a combination thereof. Among them, the vapor phase method is particularly preferred. As the vapor phase method, there can be exemplified PVD such as a sputtering method and vacuum evaporation, and CVD, When the flexible good conductive layer is constituted by the adhesive layer and the conductive layer, the respective layers may be adhered by the same method or by different methods.

The conductive sheet (A) with the flexible good conductive layer and the nanconductive sheet (B) may be the sheets of a single kind like the above conductive sheet or may be collections of sheets of different kinds. Alternately stacking means that the conductive sheet (A) with the flexible good conductive layer and the nonconductive sheet (B) are altemately stacked in any order, which, however, does not exclude interposing a third sheet, a film or any other members between the conductive sheet (A) with the flexible good conductive layer and the nonconductive sheet (B). In the step of stacking the sheets, further, a coupling agent may be applied among the sheets so that the sheets are coupled together. The laminate (C) prepared by stacking may be heated from the standpoint of promoting the curing of the sheets themselves for increasing the coupling among the sheets or for any other purpose.

The laminate (C) can be cut by using a blade such as a cemented carbide cutter or a ceramic cutter, by using a grindstone such as a fine cutter, by using a saw, or by using any other cutting device or cutting instrument (which may include a cutting device of the non-contact type, such as laser cutter). In the step of cutting, further, there may be used a cutting fluid such as a cutting oil to prevent over-heating, to obtain finely cut surfaces or for any other purpose, or a dry cutting may be employed. Further, the object to be cut may be cut alone or by being rotated together with the cutting machine or instrument. It needs not be pointed out that a variety of conditions for cutting are suitably selected to meet the laminate (C). To cut maintaining a predetermined thickness means the cutting to obtain a sheet having a predetermined thickness. The predetermined thickness needs not be uniform but may vary depending upon the places of the sheet.

The step of obtaining the laminate (E) by alternately stacking the zebra-like sheet and the sheet (D) is the same as the step of obtaining the laminate (C) from the sheet (A) and the sheet (B). Further, the step of cutting the laminate (E) maintaining a predetermined thickness is the same as the step of cutting the laminate (C).

### BRIEF DESCRIPTION OF THE DRAWINGS

Fig. 1 is a schematic perspective view illustrating a multi-layered flexible good conductive layer according to an embodiment of the present invention.
Fig. 2 is a schematic perspective view illustrating a multi-layered flexible good conductive layer according to another embodiment of the present invention, with a broken surface for explaining a mechanism thereof.
Fig. 3 is a perspective view illustrating, with partially broken portions, an anisotropic conductive sheet with a multi-layered flexible good conductive layer as different patterns are shown across the broken surfaces of a boundary according to an embodiment of the present invention.
Fig. 4 is a view illustrating, partly on an enlarged scale, the upper left portion of the anisotropic conductive sheet with the mufti-layered flexible good conductive layer shown in Fig. 3 according to the embodiment of the present invention.
Fig. 5 is a view illustrating a method of manufacturing an anisotropic conductive sheet with the multi-layered flexible good conductive layer according the embodiment of the present invention, and shows a conductive sheet with the multi-layered flexible good conductive layer.
Fig. 6 is a view illustrating the method of manufacturing the anisotropic conductive sheet with the multi-layered flexible good conductive layer according to the embodiment of the present invention, and shows a step of laminating the conductive sheet with the multi-layered flexible good conductive layer and a nonconductive sheet.
Fig. 7 is a view illustrating the method of manufacturing the anisotropic conductive sheet with the multi-layered flexible good conductive layer according to the embodiment of the present invention, and shows a step of laminating the conductive sheet with the multi-layered flexible good conductive layer laminated in Fig. 6 and the nonconductive sheet.
Fig. 8 is a view illustrating the method of manufacturing the anisotropic conductive sheet with the multi-layered flexible good conductive layer according to the embodiment of the present invention, and shows a step of laminating the sheet cut in Fig. 7 and the nonconductive sheet.
Fig. 9 is a view illustrating the method of manufacturing the anisotropic conductive sheet with the multi-layered flexible good conductive layer according to the embodiment of the present invention, i.e., illustrating a step of cutting the laminate obtained in Fig. 8.
Fig. 10 is a flowchart illustrating a method of preparing an AB sheet laminate (C) and a zebra-like sheet in the method of manufacturing the anisotropic conductive sheet with the multi-layered flexile good conductive layer according to the embodiment of the present invention.
Fig. 11 is a flowchart illustrating a method of preparing an anisotropic conductive sheet from the zebra-like sheet and the like sheet in the method of manufacturing the anisotropic conductive sheet with the multi-layered flexible good conductive layer according to the embodiment of the present invention.
Fig. 12 is a plan view of the anisotropic conductive sheet with the multi-layered flexible good conductive layer according to another embodiment of the present invention.
Fig, 13 is a sectional view of the anisotropic conductive sheet with the mufti-layered flexible good conductive layer along A-A in Fig. 12 according to another embodiment of the present invention.
Fig. 14 is a sectional view of the anisotropic conductive sheet with the multi-layered flexible good conductive layer along B-B in Fig. 12 according to another embodiment of the present invention.

### DESCRIPTION OF THE PREFERRED EMBODIMENT

The present invention will now be described in further detail by way of embodiments with reference to the drawings. However, the embodiments are simply to illustrate concrete materials and numerical values as preferred examples of the present invention, but are not to limit the present invention.

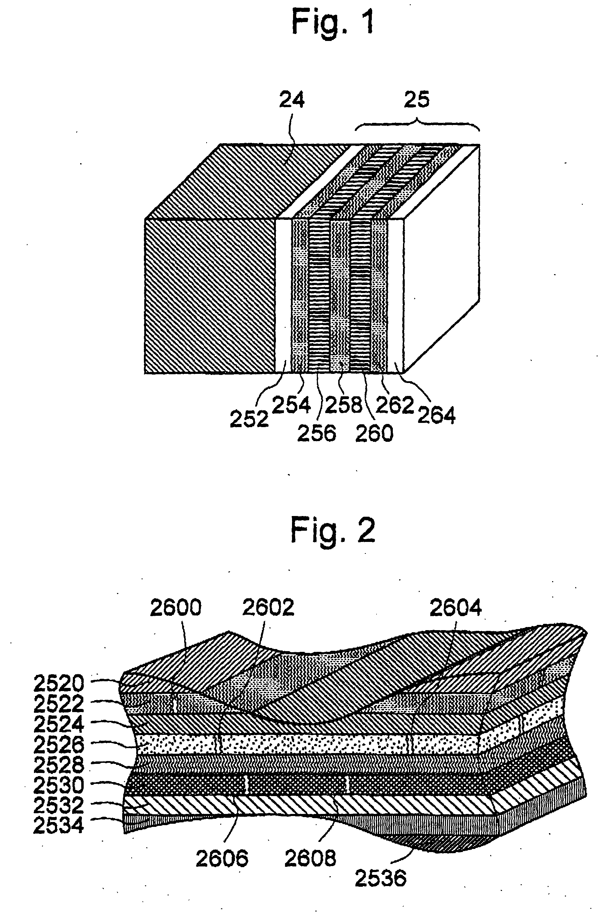

Fig. 1 schematically illustrates a flexible good conductive layer 25 according to an embodiment of the present invention in a form adhered to a base member 24. The base member 24 is made of a flexible material and, in this embodiment, is made of a conductive elastomer. The above elastomer is manufactured, for example, by Shin-etsu polymer Co. In this embodiment, therefore, the elastomer is a conductive silicone rubber manufactured by Shin-etsu Polymer Co. Carbon particles are dispersed in the elastomer matrix such as silicone rubber to impart electric conductivity.

The flexible good conductive layer 25 is constituted by an adhesive layer 252, a layer (flexible layer) 254 made of a flexible metal, a layer (good conductive layer) 256 made of a good conductive metal, a layer 258 made of a flexible metal, a layer 260 made of a good conductive metal, a layer 262 made of a flexible metal and an adhesive layer 264 in order of separating away from the surface of the base member 24. In this embodiment, the adhesive layers 252 and 264 are both made of indium tin oxide. In other embodiments, however, the two adhesive layers may be made of different materials, e.g., one adhesive layer being indium tin oxide and the other adhesive layer being made of a different material. The adhesive layers should work to harmonize physical properties to major portions of the flexible good conductive layer and to improve adhesion.

The layers 254, 258 and 262 made of a flexible metal of this embodiment are all made of the same material, In other embodiments, however, they may all be made of different materials, or some of them may be made of the same material. The layers 254, 258, 262 made of a flexible metal of this embodiment are made of indium. In a different embodiment, an indium tin alloy was used in the same structure.

The layers 256 and 260 made of a good conductive metal of this embodiment are made of the same material. In other embodiments, however, they may be made of different materials, or the one may be made of a different material. The layers 256 and 260 made of a good conductive metal of this embodiment are made of copper.

In this embodiment, the layer 254 made of a flexible metal is arranged neighboring the adhesive layer 252. If the effect due to the distortion of the substrate is considered, however, it is further desired to arrange the layer 254 made of a flexible metal and, then, arrange the layer 256 made of a good conductive metal. Besides, the layer 256 made of the good conductive metal is sandwiched by the layer 258 made of a further flexible metal to flexibly cope with the distortion of the base member 24. The next layer 260 made of a good conductive metal maintains a higher conductivity than when there is no layer 280 made of the good conductive metal. Further, being sandwiched by the layer 262 made of a flexible metal, distortion of the base member 24 is more flexibly coped with. This further makes it possible to flexibly cope with the distortion of another substrate which is probable to exist beyond the adhesive layer 264. Thus, the structure in which the layer made of a good conductive metal is sandwiched by the layers made of a flexible metal is considered to constitute a more preferred embodiment.

The multi-layered flexible good conductive layer of the embodiment is obtained by using the base member 24 as a substrate, and adhering the adhesive layer, flexible layer and good conductive layer by sputtering. The multi-layered flexible good conductive layer, however, may be prepared by any other method. In this embodiment, the base member 24 has a thickness of 50 to 70 µm, the adhesive layer 252 has a thickness of approximately 500 angstroms, the flexible layer 254 has a thickness of approximately 5000 angstroms, the good conductive layer 256 has a thickness of approximately 5000 angstroms, the flexible layer 258 has a thickness of approximately 5000 angstroms, the good conductive layer 260 has a thickness of approximately 5000 angstroms, the flexible layer 262 has a thickness of approximately 5000 angstroms, and the adhesive layer 264 has a thickness of approximately 500 angstroms. These thicknesses are suitably selected depending upon the conditions of use. Preferably, the adhesive layer has a thickness of approximately 50 angstroms to approximately 2000 angstroms and, more preferably, approximately 100 angstroms to approximately 1000 angstroms. The flexile layer has a thickness of approximately 500 angstroms to approximately 20000 angstroms and, more preferably, approximately 1000 angstroms to approximately 10000 angstroms. The good conductive layer has a thickness of approximately 500 angstroms to approximately 20000 angstroms and, more preferably, approximately 1000 angstroms to approximately 10000 angstroms.

In this embodiment, the flexible good conductive layer comprising adhesive layers and conductive layers include three flexible conductive layers and two good conductive layers. It is considered that an increase in the number of layers can withstand more large distortion, and the number of layers should be suitably selected depending upon the conditions of use. Too many number of layers, however, make the step of production complex. Therefore, too many number of layers is not necessarily desired.

Fig. 2 is a view schematically illustrating another embodiment of the present invention, and illustrates, on an enlarged scale, a portion of the conductive layers. In Fig. 2, the multi-layered flexible good conductive layer includes a flexible layer 2520, a good conductive layer 2522, a flexible layer 2524, a good conductive layer 2526, a flexible layer 2528, a good conductive layer 2530, a flexible layer 2532, a good conductive layer 2534, and a flexible layer 2536 from the upper side. These flexible layers may all be made of the same material or different materials. In this embodiment, however, the flexible layers are all made of indium. Good conductive layers may all be made of the same material or different materials. In this embodiment, copper is used for all good conductive layers.

Vertically oriented cracks 2600, 2602, 2604, 2606 and 2608 are those occurring in the good conductive layers being caused by the surrounding distortion in the base member during the handling. It is considered that the cracks occur when, for example, the flexible good conductive layer is simply pulled sideways, or when the flexible good conductive layer is on the side where the tensile stress is exerted under a condition where the flexible good conductive layer is bent in the vertical direction. The cracks in this embodiment is chiefly caused by the tensile stress and are continuing in the layer, Therefore, electricity flowing in the good conductive layer (e.g., 2526) in the transverse direction in the drawing may often be interrupted by the crack (e.g., 2602). In such a case, it is considered that the flexible layers 2524 and 2528 on the upper side and lower side of the layer 2526 take over the current flowing through the layer 2526 at a portion of the crack 2602 and return the current back to the layer 2526 again.

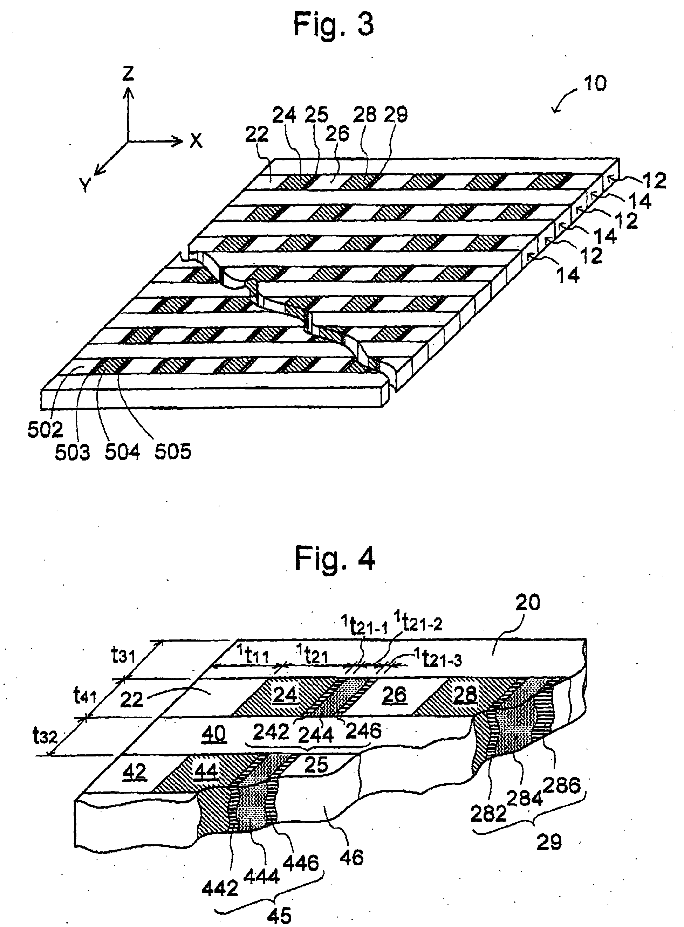

Fig. 3 illustrates an anisotroplc conductive sheet 10 according to an embodiment of the present invention using the flexible good conductive layer. A Cartesian coordinate system XYZ of the anisotropic conductive sheet 10 is illustrated at a left upper part. The anisotropic conductive sheet 10 of this embodiment is a rectangular sheet member but may be a sheet member of a shape other than the rectangular shape. The anisotropic conductive sheet 10 has a constitution in which there are alternately arranged strip-like members 12 made of nonconductive members and strip-like members 14 of a striped pattern having conductive pieces 24, 28 which are conductive members and nonconductive pieces 22, 26 which are nonconductlve members, that are alternately arranged. The strip-like members 12 made of the nonconductive members and the strip-like members 14 of the striped pattern, that are neighboring to each other, are coupled together by using a coupling agent. The strip-like members 14 of the striped pattern are constituted by nonconductive members 22, 26, conductive members 24, 28, and flexible good conductive layers 25, 29 in contact with the conductive members 24, 28. The members made of the nonconductive material constitute the nonconductive matrix, and the members made of the conductive material constitute conductive portions. When the conductive portions are scattering, the scattering conductive portions are obtained. Therefore, the scattered conductive portions exist in the nonconductive matrix in a scattered manner. In the anisotropic conductive sheet of this embodiment, the conductive elastomer is a conductive silicone rubber manufactured by Shin-etsu Polymer Co., the nonconductive elastomer is a silicone rubber manufactured by Mitsubishi Jushi Co. or a silicone rubber manufactured by Shin-etsu Polymer Co., and the coupling agent is a silane coupling agent manufactured by Shin-etsu Polymer Co. Further, the flexible good conductive layer is the multi-layered flexible good conductive layer illustrated in Fig. 1.

Fig. 3 illustrates, on the left lower portion thereof, the anisotropic conductive sheet according to another embodiment with the broken surface as a boundary. The constitution of this embodiment is the same as that of the above embodiment except that the flexible good conductive layers are adhered on both sides of the conductive members. For instance, flexible good conductive layers 503 and 505 are adhered on both sides of the conductive member 504 neighboring the nonconductive member 502 to improve the conductivity in the direction of thickness of the sheet.

Fig. 4 is a view illustrating on an enlarged scale the left upper comer portion of Fig. 3, i.e., illustrates the strip-like members 12 and 14 in further detail. The strip-like members 12 made of nonconductive members of Fig. 3 correspond in Fig. 4 to strip-like members 20, 40, etc. As for the strip-like member 14 of the striped pattern of Fig. 3, the strip-like member including nonconductive pieces 22, 26, ···, conductive pieces 24, 28 ··· and flexible good conductive layers 25, 29, correspond to the strip-like member including nonconductive members, 42, 46 ···, conductive members 44 ··· and flexible good conductive layers 45 ···, Namely, the nonconductive strip-like member 20 is neighbored by a strip-like member including nonconductive pieces 22, 26, ···, conductive pieces 24, 28, ··· and flexible good conductive layers 25, 29, ···, which is further neighbored by a nonconductive strip-like member 40, and is further neighbored by a strip-like member including nonconductive members 42, 46, ···, conductive members 44, ··· and flexible good conductive layers 45, ···. In this embodiment, the strip-like members have substantially the same thickness (T). The two strip-like members which are neighboring as described above are coupled together with the coupling agent. The conductive members with the flexible good conductive layers and the nonconductive members that are neighboring to constitute the strip-like members 14 of the striped pattern, too, are coupled with the coupling agent to constitute a piece of sheet as shown in Fig. 3. Here, the coupling agent is nonconductive, and the sheet maintains the non-conductivity in the direction of a plane.

The flexible good conductive layer 25 at the extreme left upper position is constituted by adhesive layers 242, 246 having thicknesses ¹t₂₁₋₁ and ¹t₂₁₋₃ and by a conductive layer 244 having a thickness ¹t₂₁₋₂. Similarly, other flexible good conductive layers 29, 45 are, respectively, constituted by adhesive layers 282, 286, conductive layer 284, adhesive layers 442, 446 and conductive layer 444. In this embodiment, the adhesive layers are arranged on both sides of the conductive layer. In other embodiments, however, the adhesive layer may be arranged in either side only. It is, however, desired that the adhesive layer is at least between the conductive member and the conductive layer. The nonconductive strip-like members 20, 40, ··· have widths t₃₁, t₃₂, t₃₃, ···, t₃ₖ (k is a natural number), and the strip-like members 14 of the striped pattern have widths t₄₁, ···, t₄ₖ (k is a natural number), in this embodiment, these widths are all the same. In other embodiments, however, the widths may be all the same or may be all different. These widths can be easily adjusted in the method of producing the anisotropic conductive sheet of the embodiment that will be described later. Further, the strip-like members 14 of the striped pattern are constituted by nonconductive pieces 22, 26, ···, 42, 46, ··· having lengths ¹t₁₁, ···, ¹t₁ₘ (m is a natural number); ²t₁₁, ²t₁₂, ²t₁₃, ···, ²t₁ₙ (n is a natural number), and conductive members 24, 28, ···, 44, and flexible good conductive layer 25, 29, ···, 45, ···. In this embodiment, the lengths of these nonconductive members and conductive members are all the same. In other embodiments, however, the lengths may be all the same or may be all different. These lengths can be easily adjusted in the method of producing the anisotropic conductive sheet of the embodiment that will be described later. In this embodiment, the conductive members in the strip-like members of the striped pattern have a length of approximately 50 µm, the nonconductive members have a length of approximately 30 µm, the strip-like members of the striped pattern have a width of approximately 50 µm and the nonconductive strip-like members have a width of approximately 50 µm. In other embodiments, however, the lengths may be longer (or larger) or shorter (or smaller), as a matter of course.

The extreme left upper flexible good conductive layer 25 in this embodiment is constituted by the adhesive layer 242 in contact with the conductive member 24, the conductive layer 244 in contact with the adhesive layer 242, and the adhesive layer 246 in contact with the conductive layer 244, the adhesive layer 246 being in contact with the nonconductive member 26. If they are corresponded to each of.the portions of Fig. 1, the adhesive layer 242 corresponds to the adhesive layer 252, the conductive layer 244 is constituted by the flexible layers 254, 258, 262 and good conductive layers 256, 260, and the adhesive layer 246 corresponds to the adhesive layer 264.

In general, it is desired that the flexible good conductive layer is thinner than the length (e.g., ¹t₂₁) of the conductive member, more preferably, thinner than 1/10 thereof and, particularly preferably, thinner than 1/50 thereof. When the width of the strip-like member 40 and the like is as great as 0.1 mm or more, it is desired that the conductive thin layer (metal layer when a metal is used) has a thickness of not larger than 10 µm. In this embodiment, for example, the thickness ¹t₂₁₋₁ of the adhesive layer 242 is approximately 500 angstroms, the thickness ¹t₂₁₋₂ of the conductive layer 244 is approximately 5000 angstroms, and the thickness ¹t₂₁₋₃ of the adhesive layer 246 is approximately 500 angstroms.

In the case of this embodiment, the recurring distance is a value obtained by adding up the lengths of the two neighboring elastomers of different kinds, which is divided by 2, i.e., [(^{k}t₁ₘ + ^{k}t₂ₘ)/2] or [(^{k}t₁ₘ + ^{k}t₂₍ₘ₋₁₎)/2] (k and m are natural numbers). Here, the thickness of the adhesive layer has not been taken into consideration. This is because the thickness is usually very small as compared to their lengths (when great, it is desired that the thickness is also taken into consideration). As for the whole anisotropic conductive sheet, an average value of these values may be used, a minimum value may be used, or a minimum value or an average value of a required place of the sheet may be used. When the average value is used, the sheet as a whole exhibits fine pitch performance. When the minimum vale is used, a minimum gap between the terminals that can be guaranteed is defined. When the conductive elastomer is arranged relatively uniformly, further, the frequency of appearance of the conductive elastomer per a predetermined length may be used or the cumulative length of the conductive elastomer may be used in the strip-like members of the striped pattern. In this embodiment, the recurring distance is approximately 40 µm even if an average value or a minimum value is used, and the cumulative length of the conductive elastomer per a unit length is approximately 0.6 mm/mm.

The size of the anisotropic conductive sheet of this embodiment can be clearly indicated by adding up the widths and lengths described above. However, there is no limitation on the width or on the length and there is no limitation, either, on the thickness T. When used for connecting the circuit board to the terminals of the electronic parts, however, it is desired that the size matches with these sizes. In this case, the sizes are, usually, 0.5 to 3.0 cm x 0.5 to 3.0 cm and 0.5 to 2.0 mm In thickness.

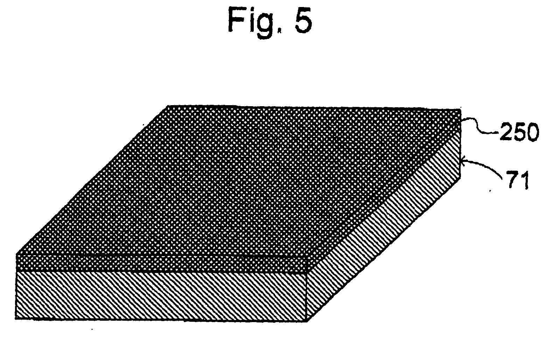

A method of manufacturing the anisotropic conductive sheet of the above embodiment will now be described with reference to Figs. 5 to 8. Fig. 5, illustrates a conductive sheet 71 having a flexible good conductive layer 250 adhered on the upper side thereof. The flexible good conductive layer 250 can be adhered by various methods but is adhered by sputtering in this embodiment. Namely, the conductive sheet 71 is used as a substrate, a target is adjusted to meet the components of the flexible good conductive layer to be prepared, and the flexible good conductive layer is adhered by using a sputtering device. The conductive sheet of this embodiment is a conductive elastomer, and contrivance should be so made that the substrate temperature is not excessively elevated. For instance, there is used a magnetron sputtering or an ion beam sputtering.

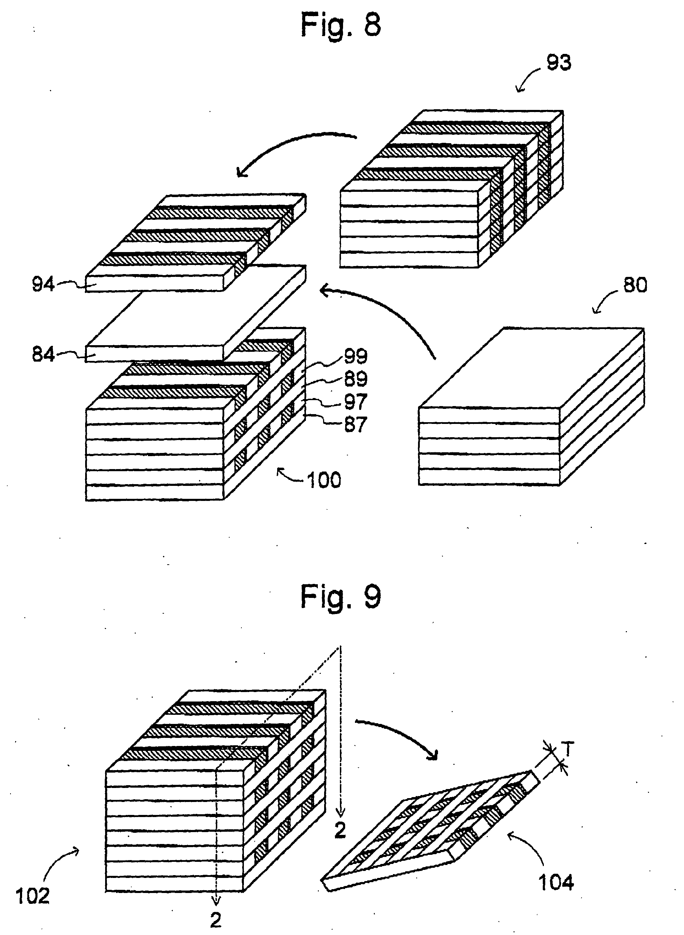

Referring to Fig. 8, there are provided conductive sheets (A) 70 with the flexible good conductive layer and nonconductive sheets (B) 80, from which the sheet members are alternately stacked to prepare an AB sheet laminate (C) 90. On the AB sheet laminate (C) 90 being stacked, there are further stacked the nonconductive sheet (B) 82 and the conductive sheet (A) 72 with the flexible good conductive layer further thereon. A coupling agent is applied among these sheets so that the sheets are coupled together. The nonconductive sheet (B) 83 is arranged at the lowest part of the AB sheet laminate (C) 90 which is being stacked. It should be noted that the thickness of this sheet member corresponds to ¹t₁₁ in Fig. 4, the thickness of the conductive sheet (A) 73 just thereon corresponds to ¹t₂₁ in Fig. 4, and the thicknesses of the sheets 84, 74, 85, 75 correspond, respectively, to the lengths of the conductive pieces and nonconductive pieces in Figs. 3 and 4. That is, lengths of the nonconductive members and of the conductive members with the flexible good conductive layer in the strip-like member 14 of the striped pattern In Figs. 3 and 4 can be freely varied by varying the thickness of these sheets. Similarly, lengths of the members (lengths of the conductive pieces and of the nonconductive. pieces) of the strip-like member of the striped pattern sandwiched between the nonconductive members 40, correspond to the thickesses of the corresponding nonconductive sheet (B) and the conductive sheet (A). Usually, as fine pitches, these thicknesses are not larger than approximately 80 µm and are, more, preferably, not larger than approximately 50 µm. In this embodiment, the thicknesses are so adjusted that the nonconductive members have a length of approximately 30 µm and the conductive members have a length of approximately 50 µm.

To alternately stack the conductive sheets (A) and nonconductive sheets (A), the conductive sheets (A) may be continuously stacked in two or more pieces and, then, the nonconductive sheets (B) may be stacked in one or more pieces. The present invention may further include continuously stacking two or more pieces of nonconductive sheets (B) and, then, stacking one or more pieces of conductive sheets (A) alternately.

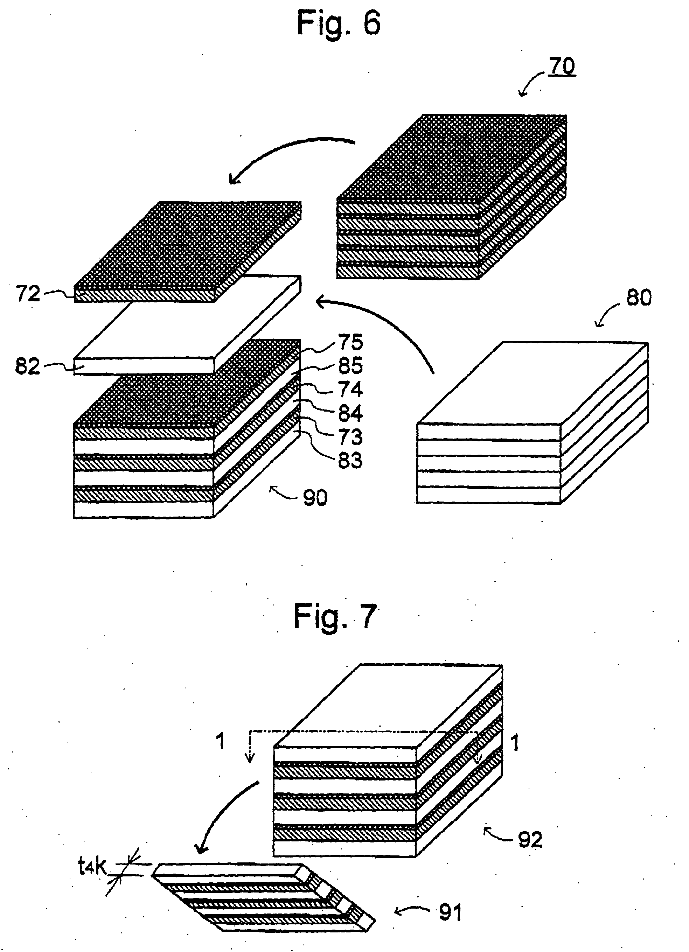

Fig. 7 illustrates a step of cutting the AB sheet laminate (C) 92 obtained by the above step. The AB sheet laminate (C) 92 is cut along a cutting line 1-1 such that the thickness of the obtained zebra-like sheet 91 has a desired thickness t₄ₖ (k is a natural number). This thickness t₄ₖ corresponds to t₄₁ in Figs. 3 and 4. Thus, the widths of the strip-like members 14 of the striped pattern in Figs. 3 and 4 can be freely adjusted, and may all have the same width or different widths. Usually, the widths are not larger than approximately 80 µm and, more desirably, not larger than approximately 50 µm. In this embodiment, the widths are approximately 50 µm.

Fig. 8 illustrates the preparation of the zebra-D sheet laminate (E) by alternately laminating the zebra-like sheet 93 prepared in the above step and the nonconductive sheet (D) 80. On the zebra-D sheet laminate (E) 100 being stacked, there are further stacked the nonconductive sheet (D) 84 and the zebra-like sheet 94 thereon. A coupling agent is applied among these sheets so that the sheets are coupled together. The nonconductive sheet (D) 87 is arranged at the lowest part of the zebra-D sheet laminate (E) 100 which is being stacked. It should be noted that the thickness of this sheet corresponds to t₃₁ which Is the width of the nonconductive strip-like member 12 in Fig. 4, the thickness of the zebra-like sheet 97 just thereon corresponds to t₄₁ in Fig, 4, and the thickness of the nonconductive sheet (D) 89 corresponds to t₃₂ in Fig, 4. That Is, lengths of the two kinds of strip-like members 12 and 14 in Figs. 3 and 4 can be freely varied by varying the thickness of these sheet. Usually, as fine pitches, these thicknesses are not larger than approximately 80 µm and are, more, preferably, not larger than approximately 50 µm. In this embodiment, the thicknesses are so adjusted that the nonconductive strip-like members 12 have a width of approximately 30 µm and the strip-like members 14 of the striped pattern have a length of approximately 50 µm.

Fig. 9 illustrates the step of cutting the zebra-D sheet laminate (E) 102 obtained through the above step. The zebra-D sheet laminate (E) 102 is cut along a cutting line 2-2 such that the obtained anisotropic conductive sheet 104 will have a desired thickness T. Therefore, this makes it easy to prepare a thin anisotropic conductive sheet and a thick anisotropic conductive sheet which are usually difficult to obtain. Though the thickness is usually approximately 1 mm, the thickness can be decreased to be approximately 100 µm (or not larger than approximately 50 µm when particularly desired) or can be increased to be approximately several millimeters. In this embodiment, the thickness is selected to be approximately 1 mm.

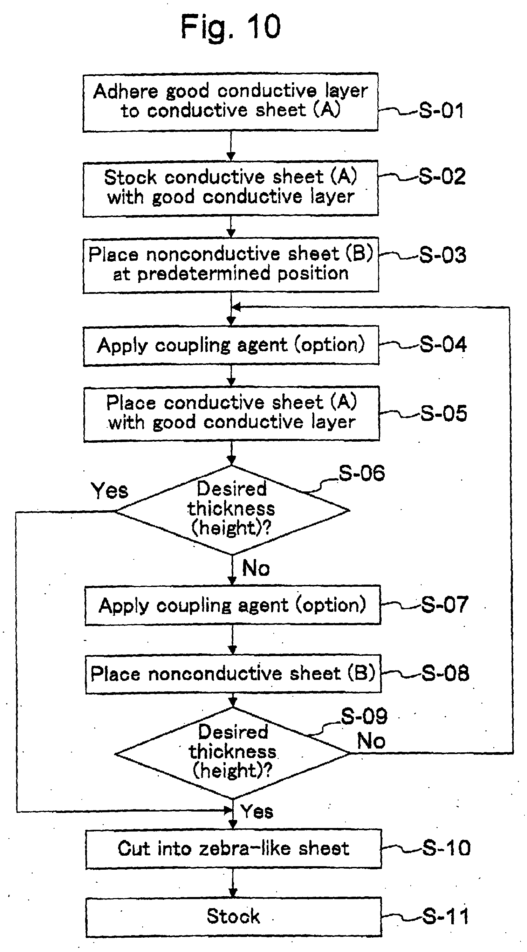

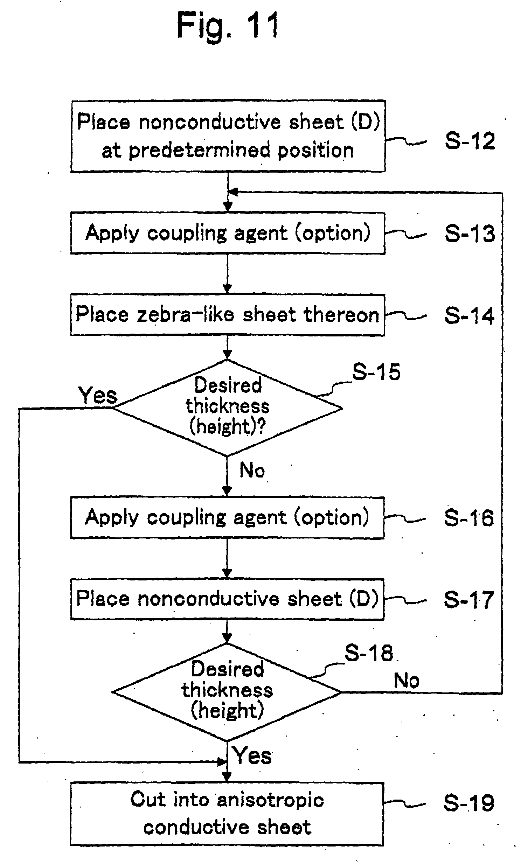

Figs. 10 and 11 are flowcharts illustrating a method of manufacturing the above anisotropic conductive sheet. Fig. 10 illustrates steps of preparing the zebra-like sheet. First, the flexible good conductive layer is adhered on the conductive sheet (A) (S-01). In this embodiment, the flexible good conductive layer Is formed by sputtering on one surface only of the conductive sheet. The conductive sheet (A) with the flexible good conductive layer is stocked for use in the next step (S-02). Next, the nonconductive sheet (B) is placed at a predetermined position for stacking (S-03). Optionally, the coupling agent is applied onto the nonconductive sheet (B) (S-04). The conductive sheet (A) with the flexible good conductive layer is placed thereon (S-05). Check if the thickness (or height) of the stacked AB sheet laminate (C) is reaching a desired thickness (or height) (S-06). If the desired (predetermined) thickness has been reached, the routine proceeds to the first step of cutting (S-10). If the desired (predetermined) thickness has not been reached, the coupling agent is optionally applied onto the conductive sheet (A) (S-07). The nonconductive sheet (B) is placed thereon (S-08). Check if the thickness (or height) of the stacked AB sheet laminate (C) is reaching a desired thickness (or height) (S-09). If the desired (predetermined) thickness has been reached, the routine proceeds to the first step of cutting (S-10). If the desired (predetermined) thickness has not been reached, the routine returns back to step S-04 where the coupling agent is optionally applied onto the conductive sheet (A). At the step of cutting (S-10), the zebra-like sheet is cut out piece by piece or in a plurality of number of pieces at one time, and the zebra-like sheets are stocked (S-11).

Fig. 11 illustrates steps of obtaining an anisotropic conductive sheet from the zebra-like sheet and the nonconductive member. First, the nonconductive sheet (D) is placed on a predetermined position for stacking (S-12). Optionally, the coupling agent is applied onto the nonconductive sheet (D) (S-13). The zebra-like sheet is placed thereon (S-14). Check if the thickness (or height) of the stacked zebra-D sheet laminate (E) is reaching a desired thickness (or height) (S-15). If the desired (predetermined) thickness has been reached, the routine proceeds to the second step of cutting (S-19). If the desired (predetermined) thickness has not been reached, the coupling agent is optionally applied onto the zebra-like sheet (S-16). The nonconductive sheet (D) is placed thereon (S-17). Check if the thickness (or height) of the zebra-D sheet laminate (E) is reaching a desired thickness (or height) (S-18), If the desired (predetermined) thickness has been reached, the routine proceeds to the second step of cutting (S-19). If the desired (predetermined) thickness has not been reached, the routine returns back to step S-13 where the coupling agent is optionally applied onto the zebra-like sheet. At the second step of cutting (S-19), the anisotropic sheet is cut out piece by piece or In a plurality of number of pieces at one time (S-18).

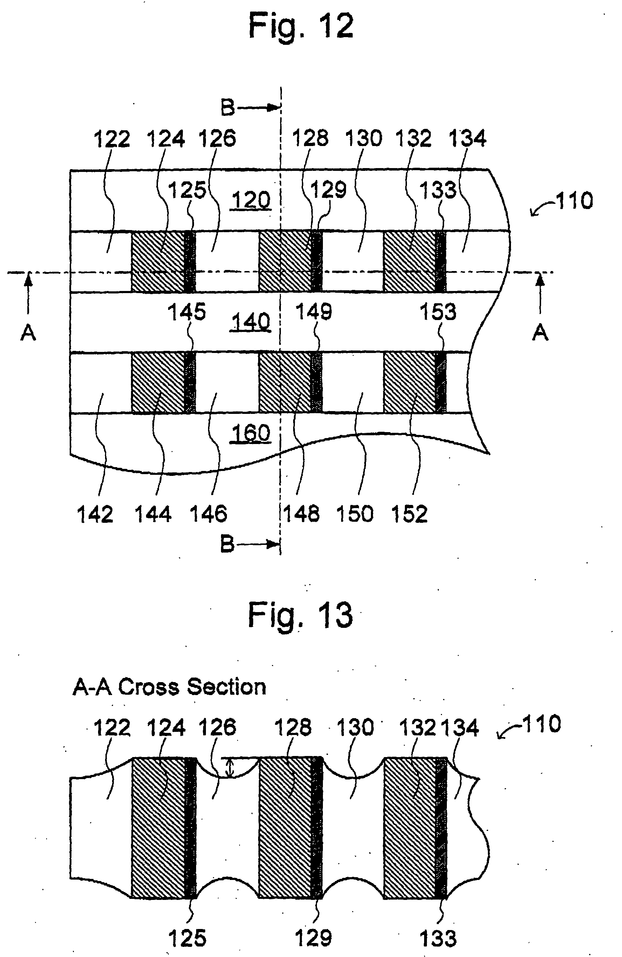

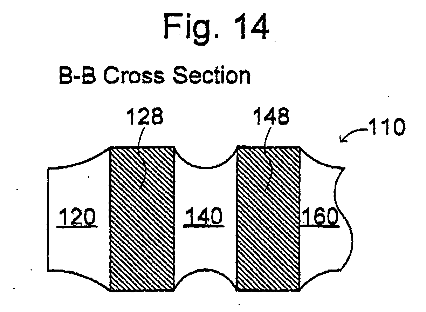

Figs. 12, 13 and 14 illustrate another embodiment. in the second embodiment, an anisotropic conductive sheet 110 is prepared according to the above method by using conductive sheets that have been cured and nonconductive sheets that have not been cured. Figs. 13 and 14 are sectional views of the anisotropic conductive sheet 110 along the lines A-A and B-B. As will be understood from these drawings, the conductive members 124, 128, 132, 148 with the flexible good conductive layer (125, 129, 133 and 149) are In a convex state and protruded on the surface of the sheet to be higher than the nonconductive members 122, 126, 130, 134, 120, 140 and 160 offering improved reliability of contact. This form is assumed since the rubber has contracted due to the curing by heating.

As described above, the flexible good conductive layer of the present invention does not lose good conduction even in case cracks has occurred In the good conductive layer. The anisotropic conductive sheet of the present invention has the effect of not only maintaining insulation In the direction of the plane while exhibiting satisfactory conductivity in the direction of thickness but also enabling the sizes such as lengths of the nonconductive members and conductive members to be freely set to easily accomplish fine pitches desired for achieving a high degree of integration.

## Claims

1. A flexible good conductive layer having flexibility so as to be adhered to a substrate made of flexible material, comprising; a flexible layer made of flexible material; and a good conductive layer made of material having good electric conductivity, the conductive layer being mechanically and electrically contacted to the flexible layer; wherein the good conductive layer is adhered to the substrate via the flexible layer.

2. The flexible good conductive layer according to claim 1, wherein the flexible layer is made of flexible metal, and wherein the good conductive layer is made of metal of good electric conductivity.

3. The flexible good conductive layer according to claim 2, wherein the flexible metal is indium, tin, lead or an alloy thereof, and wherein the metal of good electric conductivity is copper, silver, gold or an alloy thereof.

4. The flexible good conductive layer according to any one of claims 1 to 3, wherein a value of specific resistivity of the flexible material is at least two times as large as a value of specific resistivity of the material of good electric conductivity.

5. The flexible good conductive layer according to any one of claims 1 to 4, wherein an adhesive layer is disposed between the substrate to which the flexible good conductive layer is adhered and the flexible good conductive layer.

6. An anisotropic conductive sheet expanding on a first plane, wherein when a first direction contained in said first plane is denoted as X-direction, a direction orthogonal to X-direction and contained in said first plane is denoted as Y-direction and a direction orthogonal to X-direction and Y-direction is denoted as Z-direction, wherein the anisotropic conductive sheet has a predetermined thickness in Z-direction, and a front surface and a back surface substantially in parallel with the first plane, the anisotropic conductive sheet comprising: a nonconductive matrix expanding on the first plane, scattered conductive portions made of a flexible material scattered in the nonconductlve matrix, and a flexible good conductive layer of flexibility adhered to said scattered conductive portions between said scattered conductive portions and said nonconductive matrix, wherein said flexible good conductive layer comprises a flexible layer made of said flexible material arranged on the side of said scattered conductive portions serving as the base member and a good conductive layer made of material of good electric conductivity mechanically and electrically contacted to said flexible layer, wherein said good conductive layer being a flexible good conductive layer is adhered to said scattered conductive portions serving as said base member via said flexible layer.

7. The anisotropic conductive sheet according to claim 6, wherein the scattered conductive portions penetrate the anisotropic conductive sheet from the front surface to the back surface in Z-direction, and wherein the flexible good conductive layer extends along the surface of the scattered conductive portions.

8. An anisotropic conductive sheet expanding on a first plane, wherein when a first direction contained In said first plane is denoted as X-direction, a direction orthogonal to X-direction and contained in said first plane is denoted as Y-direction and a direction orthogonal to X-direction and Y-direction is denoted as Z-direction, wherein the anisotropic conductive sheet has a predetermined thickness in Z-direction, and a front surface and a back surface substantially in parallel with said first plane (X-Y plane), the anisotropic conductive sheet comprising:
strip-like members of a striped pattern having a width in Y-direction and extending in X-direction, the strip-like members including: conductive pieces of conductivity and nonconductive pieces of nonconductivity which are alternately arranged along X-direction; and
nonconductive strip-like members being made of a nonconductive material and having a width in Y-direction and extending in X-direction,
wherein the strip-like members and the nonconductive strip-like members are arranged relative to each other along Y-direction,
wherein flexible good conductive layers of flexibility adhered to said conductive pieces between said conductive pieces and said nonconductive pleces, which are neighboring in the strip-like members of a striped pattern, are provided, and
wherein said flexible good conductive layer comprises: a flexible layer made of said flexible material arranged on a side of said conductive pieces serving as a base member; and a good conductive layer made of material of good electric conductivity mechanically and electrically contacted to said flexible layer, and
wherein said good conductive layer is a flexible good conductive layer adhered to said conductive pieces serving as the base member via said flexible layer.

9. The anisotropic conductive sheet according to claim 6 or 7,
wherein the flexible good conductive layer comprises an adhesive layer arranged on a side of the base member and a conductive layer,
wherein said conductive layer comprises a flexible layer and a good conductive layer electrically contacted to the flexible layer, and
wherein said conductive layer is adhered to the substrate via said adhesive layer.

10. The anisotropic conductive sheet according to claim 9, wherein said adhesive layer is made of indium tin oxide.

11. The anisotropic conductive sheet according to claim 9 or 10, wherein the adhesive layer of the flexible good conductive layer is arranged on a side of the nonconductive matrix when the flexible good conductive layer is In contact with the nonconductive matrix.

12. The anisotropic conductive sheet according to any one of claims 6, 7 and 9 to 11, wherein the nonconductive matrix comprises a nonconductive elastomer, and the scattered conductive portions comprise a conductive elastomer.

13. The anisotropic conductive sheet according to any one of claims 6, 7 and 9 to 12, wherein the scattered conductive portions are protruded as compared to the surrounding nonconductive matrix.

14. A method of manufacturing a flexible anisotropic conductive sheet having a predetermined thickness, and predetermined front and back surfaces on the front and back across the thickness, the method comprising:
a step of adhering a flexible good conductive layer on the surface of a conductive sheet (A) made of a conductive material to obtain a conductive sheet (A) with the flexible good conductive layer;
a step of alternately laminating the conductive sheet (A) with the flexible good conductive layer obtained In the step of adhering the layers and a nonconductive sheet (B) to obtain an AB sheet laminate (C);
a first step of cutting the AB sheet laminate (C) obtained in the step of obtaining the AB sheet laminate to obtain a zebra-like sheet in a predetermined thickness;
a step of alternately laminating the zebra-like sheet obtained in the first cutting step and a nonconductive sheet (D) to obtain a ZD sheet laminate (E); and
a second step of cutting the zebra-D sheet laminate (E) obtained in the step of obtaining the ZD sheet laminate with a predetermined thickness.
